# DEMANDE DE BREVET EUROPEEN

(11) **EP 1 274 128 A1**
(43) Date de publication de la demande: **08.01.2003**
(21) Numéro de dépôt: 02291531.8
(22) Date de dépôt: 19.06.2002
(51) Int. Cl.: H01L 23/66, H01L 23/528

(54) **Dispositif semi-conducteur à structure hyperfréquence**

(30) Priorité: 28.06.2001 FR 0108558
(71) Demandeur: STMicroelectronics S.A., 92120 Montrouge (FR)
(72) Inventeur: Gloria, Daniel, 38000 Grenoble (FR); Perrotin, André, 38170 Seyssinet (FR)
(74) Mandataire: Casalonga, Axel

(57) **Abrégé**

Dispositif semi-conducteur à plusieurs niveaux, comprenant au moins une structure pour la transmission de signaux électriques, en particulier de signaux hyperfréquences, cette structure comprenant au moins une cage (4), en un matériau conducteur de l'électricité, qui comprend une plaque inférieure (5) et une plaque supérieure (6) situées à deux niveaux différents, ainsi que des parois latérales qui relient lesdites plaques, et au moins une bande de connexion (38), en un matériau conducteur de l'électricité, qui s'étend dans ladite cage et qui est située dans un niveau intermédiaire et isolée électriquement de ladite cage, ladite cage présentant au moins un passage traversant (35) au travers duquel s'étendent des moyens de connexion électrique (37) de ladite bande de transmission, isolés électriquement de ladite cage.

## Description

La présente invention concerne le domaine des dispositifs semi-conducteurs à circuits intégrés.

Le but de la présente invention est de proposer une structure, à encombrement limité, permettant une transmission interne de signaux électriques, en particulier de signaux hyperfréquences, de telle sorte que ces derniers soient soumis de façon réduite aux parasites ou aux effets du bruit.

Dans une application, le but de la présente invention est de proposer une structure permettant de tester, par des mesures en hyperfréquence, des paramètres des circuits intégrés tels que les fréquences de transition, les fréquences d'oscillation et les facteurs de bruit.

Le dispositif semi-conducteur à plusieurs niveaux selon l'invention comprend au moins une structure pour la transmission de signaux électriques, en particulier de signaux hyperfréquences,

Selon l'invention, cette structure comprend au moins une cage, en un matériau conducteur de l'électricité, qui comprend une plaque inférieure et une plaque supérieure situées à deux niveaux différents, ainsi que des parois latérales qui relient lesdites plaques, et au moins une bande de connexion, en un matériau conducteur de l'électricité, qui s'étend dans ladite cage et qui est située dans un niveau intermédiaire et isolée électriquement de ladite cage, ladite cage présentant des passages traversant au travers desquels s'étendent des moyens de connexion électrique de ladite bande de transmission, isolés électriquement de ladite cage.

Selon l'invention, les parois de ladite cage comprennent de préférence des bandes réalisées dans des niveaux intermédiaires,
lesdites plaques et ces bandes étant reliées respectivement par des vias de connexion.

Selon une variante de l'invention, ladite bande de transmission comprend au moins deux parties reliées respectivement à deux parties d'au moins un composant électronique intégré.

Selon l'invention, ladite cage peut avantageusement comprendre au moins une ouverture pour le passage de moyens de connexion électrique dudit composant électronique intégré, ce dernier étant placé à l'extérieur de ladite cage.

Selon l'invention, ladite plaque supérieure peut avantageusement présenter au moins trois parties dont deux sont isolées électriquement et reliées à ladite bande de transmission.

Selon l'invention, ladite plaque inférieure peut avantageusement présenter au moins un passage traversant au travers duquel s'étendent des moyens de connexion électrique de ladite bande de transmission à un composant électronique intégré, ce dernier étant placé en dessous de cette plaque inférieure.

Selon une variante d'application, le dispositif selon l'invention peut être implanté dans un circuit intégré.

Selon une autre variante d'application, le dispositif selon l'invention peut être implanté dans un endroit d'une plaquette de circuits intégrés formant une zone de découpe entre ces derniers.

La présente invention sera mieux comprise à l'étude de dispositifs semi-conducteurs incluant des structures de connexion électrique, décrits à titre d'exemples non limitatifs et illustrés par le dessin sur lequel :
- la figure 1 représente une coupe longitudinale médiane d'une structure selon la présente invention, repérée I-I sur la figure ;
- la figure 2 représente 1 une coupe longitudinale de la structure de la figure 1, proche de son bord longitudinal et repéré II-II sur la figure ;
- la figure 3 représente une coupe en plan du premier niveau de métallisation de la structure de la figure 1, repéré M1 sur cette figure ;
- la figure 4 représente une coupe en plan du second niveau de métallisation de la structure de la figure 1, repéré M2 cette figure ;
- la figure 5 représente une coupe en plan du troisième niveau de métallisation de la structure de la figure 1, repéré M3 sur cette figure ;
- la figure 6 représente une coupe en plan du quatrième niveau de métallisation de la structure de la figure 1, repéré M4 sur cette figure ;
- la figure 7 représente une coupe en plan du cinquième niveau de métallisation de la structure de la figure 1, repéré M5 sur cette figure ;
- la figure 8 représente une coupe transversale médiane de la structure de la figure 1, selon VIII-VIII de cette figure ;
- la figure 9 représente une coupe transversale proche de la partie médiane de la structure de la figure 1, selon IX-IX de cette figure ;
- la figure 10 représente une coupe transversale plus éloignée de la partie médiane de la structure de la figure 1, selon X-X de cette figure ;
- la figure 11 représente une coupe transversale proche du bord latéral de la structure de la figure 1, selon XI-XI de cette figure ;
- la figure 12 représente une coupe longitudinale médiane d'une autre structure selon la présente invention ;
- la figure 13 représente une coupe tranversale médiane de la structure de la figure 12, selon XIII-XIII de cette figure ;
- et la figure 14 représente une coupe longitudinale médiane d'une autre structure selon la présente invention.

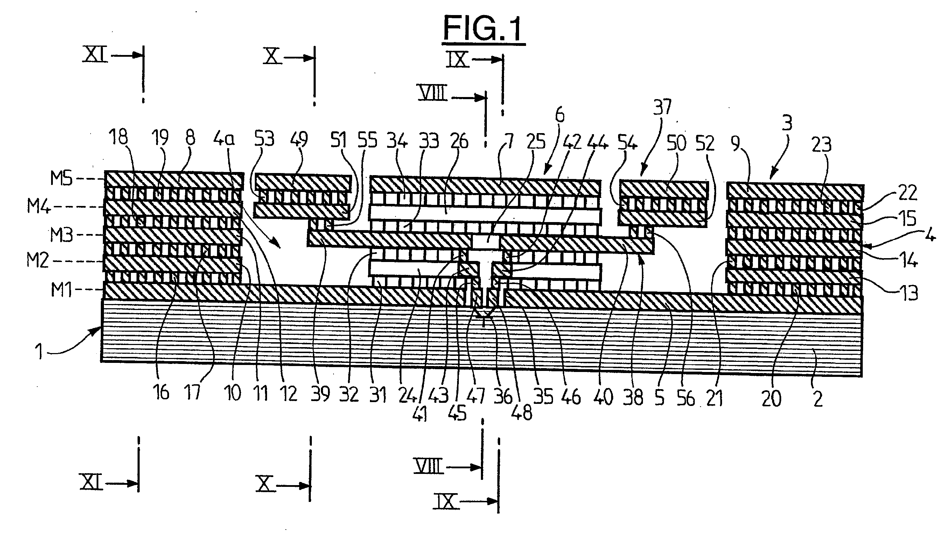

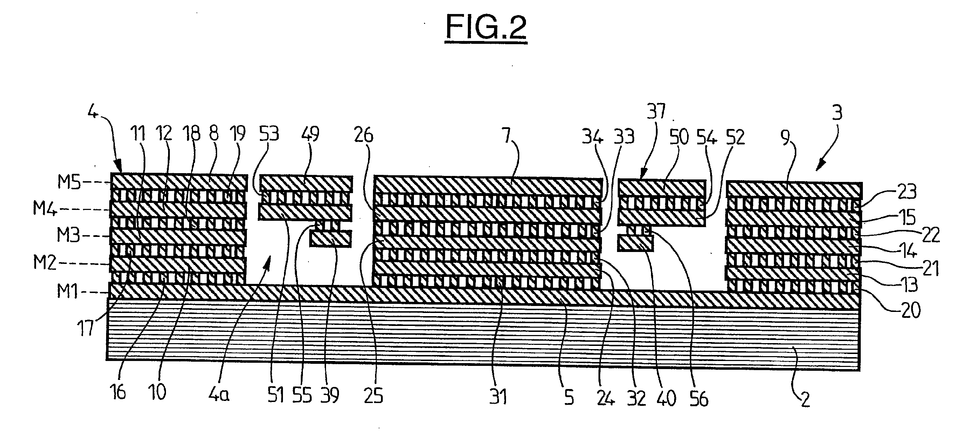

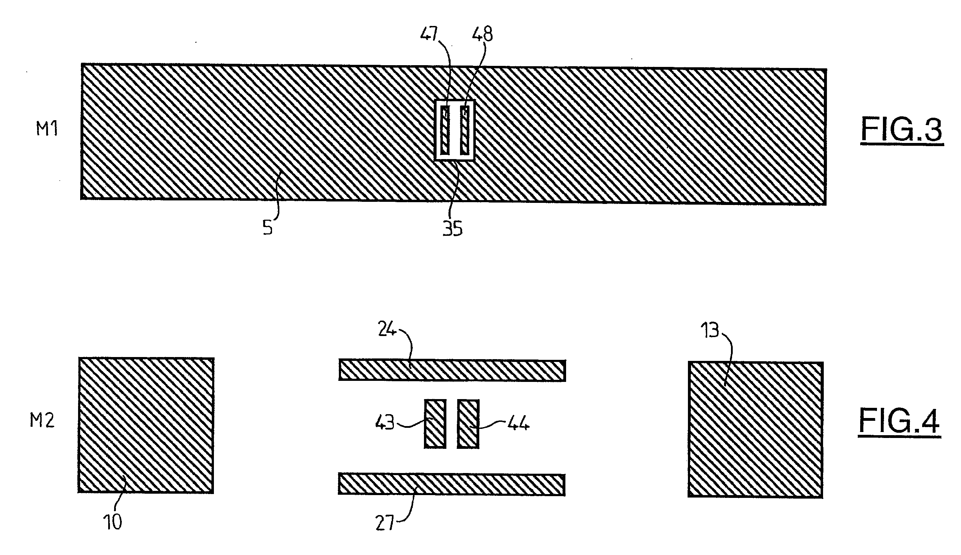

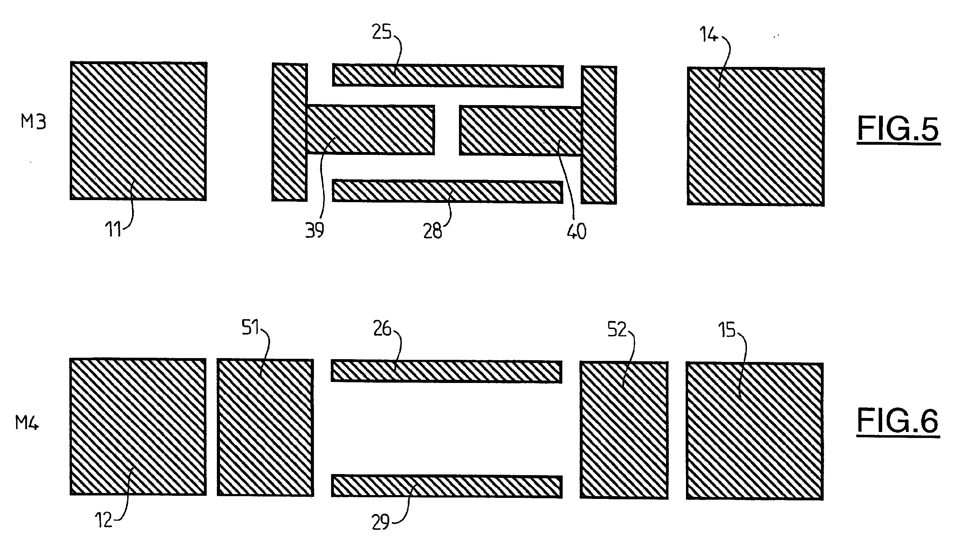

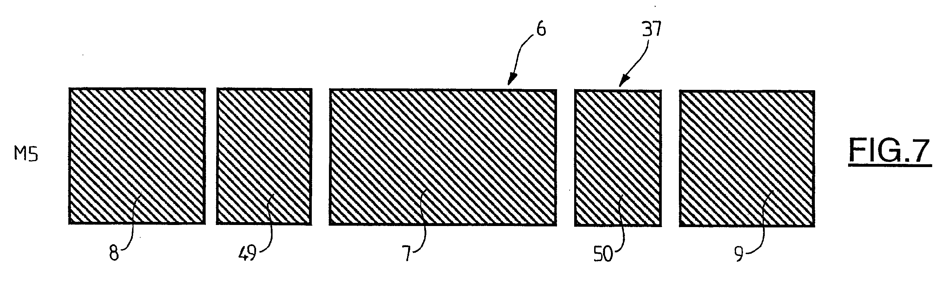

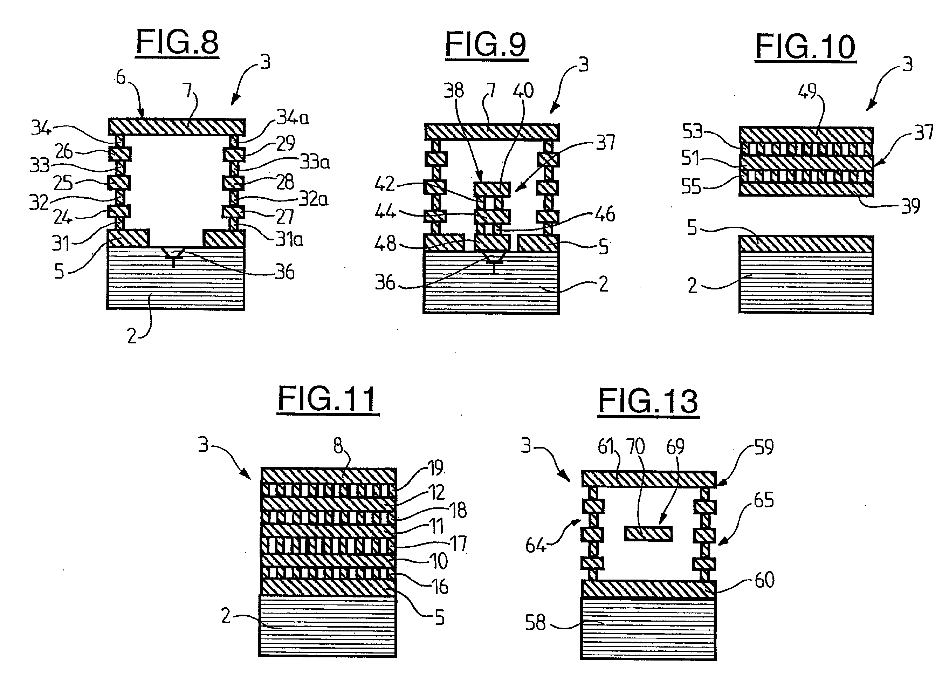

En se reportant aux figures 1 à 11, on voit qu'on a représenté un dispositif semi-conducteur 1 qui comprend, sur une plaquette de base 2 à composants intégrés, une structure 3 pour la transmission de signaux électriques, en particulier de signaux en hyperfréquence, réalisée sur plusieurs niveaux de matériaux conducteurs de l'électricité, appelés généralement des niveaux de métallisation.

Dans l'exemple, la structure 3 comprend cinq niveaux successifs de métallisation M1, M2, M3, M4 et M5, le premier niveau M1 étant accolé à la plaquette de base 2. De façon habituelle, ces niveaux sont espacés par des niveaux diélectriques.

La structure 3 comprend une cage 4 dont les parois sont construites de la manière suivante.

Comme le montrent en particulier les figures 1, 2, 3 et 8 à 11, la cage 4 comprend une plaque inférieure rectangulaire 5 qui est réalisée longitudinalement dans le premier niveau de métallisation M1.

Comme le montrent en particulier les figures 1, 2, 7 et 8 à 11, la cage 4 comprend une plaque supérieure 6 qui est réalisée longitudinalement dans le cinquième niveau de métallisation M5. Cette plaque supérieure 6 comprend une partie centrale rectangulaire 7 et deux parties rectangulaires d'extrémité 8 et 9 distantes de la partie centrale 7 et recouvre la plaque inférieure 5.

Comme le montrent en particulier les figures 1, 2, 4 à 6 et 11, entre les parties d'extrémité 8 et 9 de la plaque supérieure 6, la structure 4 comprend respectivement des plaques transversales rectangulaires 10, 11 et 12 et des plaques transversales rectangulaires 13, 14 et 15 réalisées respectivement dans les niveaux intermédiaires de métallisation M2, M3 et M4.

La plaque inférieure 5, les plaques intermédiaires 10, 11 et 12 et la partie d'extrémité 8 de la plaque supérieure 6 sont respectivement reliées par quatre groupes de vias de connexion électrique 16, 17, 18 et 19 réalisés au travers des niveaux diélectriques.

La plaque inférieure 5, les plaques intermédiaires 13, 14 et 15 et la partie d'extrémité 9 de la plaque supérieure 6 sont respectivement reliées par des groupes de vias de connexion électrique 20, 21, 22 et 23 réalisés au travers des niveaux diélectriques.

Comme le montrent en particulier les figures 1, 2, 4 à 6, 8 et 9, entre les bords longitudinaux de la plaque inférieure 5 et les bords longitudinaux de la partie centrale 7 de la plaque supérieure 9, la cage 4 comprend d'une part des bandes longitudinales intermédiaires 24, 25
et 26, et d'autre part des bandes longitudinales intermédiaires 27, 28 et 29, qui sont réalisées dans les niveaux de métallisation intermédiaires M2, M3 et M4.

La plaque inférieure 5, les bandes intermédiaires 24, 25 et 26 et la partie supérieure 7 de la plaque 6 sont respectivement reliées par quatre groupes de vias de connexion électrique 31, 32, 33 et 34 réalisés au travers des niveaux diélectriques.

La plaque inférieure 5, les bandes intermédiaires 27, 28 et 29 et la partie centrale 7 de la plaque supérieure 6 sont respectivement reliées par quatre groupes de vias de connexion électrique 31a, 32a, 33a et 34a réalisés au travers des niveaux diélectriques.

Comme le montrent en particulier les figures 1, 3 et 8, la plaque inférieure 5 présente, en son centre, un passage traversant 35 en dessous duquel la plaque de base 2 présente un composant électronique intégré 36 tel qu'un transistor.

Il résulte de ce qui précède que la cage 4 délimite un espace 4a ouvert entre la partie centrale 7 et respectivement les parties d'extrémité 8 et 9 de sa plaque supérieure 6.

Comme le montrent en particulier les figures 1, 4, 5, 6, 7, 9 et 10, la structure 3 comprend en outre des moyens de connexion électrique 37, isolé électriquement de la cage 4, qui comprennent une bande longitudinale de connexion électrique 38 qui s'étend dans la cage 4 et qui est réalisée dans le troisième niveau de métallisation M3.

La bande de connexion 38 comprend deux parties longitudinales 39 et 40 dont les extrémités voisines sont respectivement reliées, par exemple, à la base et au collecteur du transistor 36, par l'intermédiaire de vias 41 et 42, de plots 43 et 44 réalisés dans le second niveau de métallisation M2, de vias de connexion 45 et 46 et de plots de connexion 47 et 48 réalisés dans le premier niveau de métallisation M1 au travers du passage 35 de la plaque inférieure 5.

Dans les passages s'étendant entre la partie centrale 7 et les parties d'extrémité 8 et 9 de la plaque supérieure 6, les moyens de connexion 37 comprennent des bandes transversales 49 et 50 réalisées
dans le cinquième niveau de métallisation M5 et des bandes transversales 51 et 52 réalisées dans le quatrième niveau de métallisation M4. Les bandes transversales 49 et 50 sont reliées par un groupe de vias de connexion 53 et les bandes transversales 50 et 52 sont reliées par un groupe de vias de connexion 54, respectivement réalisés au travers des niveaux diélectriques.

En outre, la face supérieure d'extrémité de la partie 39 de la bande longitudinale 38 est reliée à la face inférieure de la plaque transversale 51 par un groupe de vias 55 et la face supérieure d'extrémité de la partie 40 de la bande longitudinale 38 est reliée à la face inférieure de la plaque 52 au travers d'un groupe de vias de connexion 56.

Il résulte de ce qui précède que les moyens de connexion 37 sont intégrés dans la cage 4 et sont isolés électriquement de cette dernière de telle sorte que les connexions suivantes peuvent être obtenues.

D'une part, la face supérieure de la partie centrale 7 de la plaque supérieure 6 constitue une zone de contact électrique reliée à l'émetteur du transistor 36 au travers des flancs de la cage 4 et de la plaque inférieure 5.

D'autre part, les faces supérieures des bandes transversales 49 et 50 des moyens de connexion 37 constituent des zones de contacts électriques reliées à la base et au collecteur du transistor 36 au travers des deux parties de ces moyens de connexion 37 incluant resperctivement les parties 39 et 40 de la bande de connexion intérieure 38.

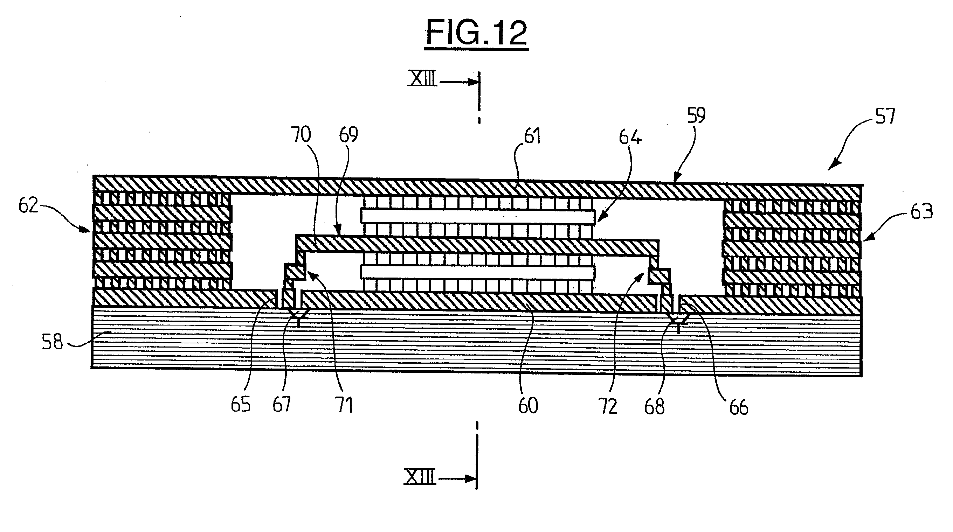

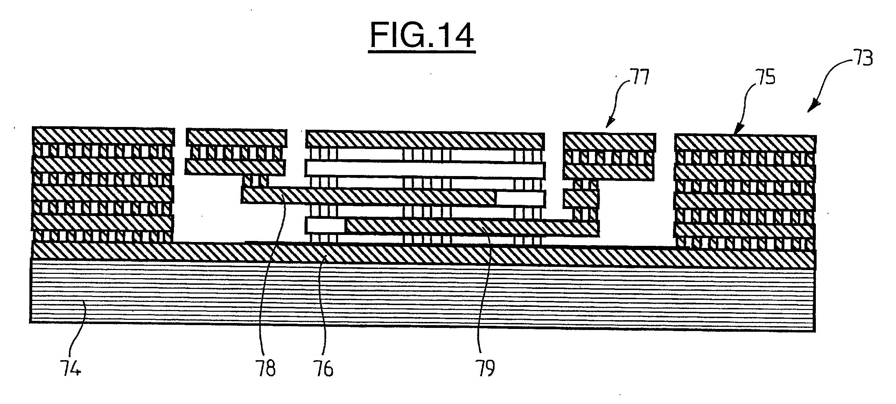

En se reportant maintenant aux figures 12 et 13, on voit qu'on a représenté une structure 57 réalisée sur une plaquette de base 58, constituant une variante d'exécution de l'exemple précédent.

La structure 57 comprend une cage 59 constituée d'une plaque longitudinale inférieure 60, d'une plaque supérieure continue 61 et, entre les parties d'extrémité de ces plaques, des empilages 62 et 63 de plaques transversales et de groupes de vias de connexion, réalisés de la même manière que ceux interposés entre la plaque
inférieure 5 et les parties 8 et 9 de la plaque supérieure 6 de l'exemple précédent, ainsi que des empilages longitudinaux 65 et 66 correspondant aux empilages de bandes longitudinales et de vias de connexion placés entre la plaque inférieure 5 et la partie centrale 7 de la plaque supérieure 6 de l'exemple précédent.

La plaque inférieure 60 présente deux passages traversants 65 et 66 en dessous desquels la plaquette de base 58 comprend des transistors 67 et 68.

La structure 57 comprend en outre des moyens de connexion électrique 69 qui comprennent une bande longitudinale de connexion 70 s'étendant à l'intérieur de la cage 69 qui, dans cette variante, est continue, ainsi que des empilages 71 et 72 constitués de plots et de vias interposés entre les parties d'extrémité de la bande longitudinale 70 et une partie de connexion des transistors 67 et 68, ces empilages 71 et 72 étant constitués de la même manière que ceux reliant les parties 39 et 40 de la bande longitudinale 38 au transistor 36 de l'exemple précédent.

Ainsi, les transistors 67 et 68 se trouvent reliés au travers de l'espace intérieur de la cage 58 par l'intermédiaire de la bande longitudinale 70 et des empilages de connexion 71 et 72, en passant au travers des passages 65 et 66 de la plaque inférieure 60.

En se reportant maintenant à la figure 14, on voit qu'on a représenté une structure 73 réalisée sur une plaquette de base 74 qui comprend une cage 75 qui ne se différencie de celle décrite en référence aux figures 1 à 11 que par le fait que sa plaque inférieure 76 est pleine, la plaquette de base 74 ne comprenant aucun composant en dessous.

La structure 73 comprend également des moyens de connexion électrique 77 qui ne se différencient de ceux décrits en référence aux figures 1 à 11 que par le fait qu'ils comprennent, dans la cage 75, deux bandes longitudinales de connexion 78 et 79 réalisées dans deux niveaux de métallisation intermédiaires différents M2 et M3 de façon à présenter des parties se recouvrant à distance.

Ces bandes longitudinales 78 et 79 pourraient avantageusement être utilisées pour connecter des capacités métalliques formées par exemple entre elles.

Dans une variante de disposition, les structures qui viennent d'être décrites peuvent être implantées dans des circuits intégrés réalisés sur des plaquettes de base, de façon à bénéficier des avantages résultant d'un blindage électromagnétique

Dans une autre variante de disposition, les structures qui viennent d'être décrites peuvent être implantées dans des endroits de plaquettes de circuits intégrés formant une zone de découpe entre ces derniers. Dans ce cas, ces structures peuvent être utilisées pour réaliser des tests en hyperfréquence des circuits en bénéficiant des mêmes avantages.

## Revendications

1. Dispositif semi-conducteur à plusieurs niveaux, comprenant au moins une structure pour la transmission de signaux électriques, en particulier de signaux hyperfréquences, **caractérisé par le fait qu'**il comprend :
au moins une cage (4), en un matériau conducteur de l'électricité, qui comprend une plaque inférieure (5) et une plaque supérieure (6) situées à deux niveaux différents, ainsi que des parois latérales qui relient lesdites plaques,
au moins une bande de connexion (38), en un matériau conducteur de l'électricité, qui s'étend dans ladite cage et qui est située dans un niveau intermédiaire et isolée électriquement de ladite cage,
au moins un composant électronique intégré (36) placé à l'extérieur de ladite cage à un niveau inférieure à ladite plaque inférieure (5),
ladite plaque inférieure (5) présentant au moins un passage traversant (35) au travers duquel s'étendent des moyens de connexion électrique (37) de ladite bande de transmission audit composant électronique intégré (36) et ces moyens de connexion électrique (37) étant isolés électriquement de ladite cage (4).

2. Dispositif selon la revendication 1, **caractérisé par le fait que** les parois de ladite cage comprennent des bandes (10) réalisées dans des niveaux intermédiaires, lesdites plaques et ces bandes étant reliées respectivement par des vias de connexion.

3. Dispositif selon l'une des revendications 1 et 2, **caractérisé par le fait que** ladite bande de transmission (38) comprend au moins deux parties (39, 40) reliées respectivement à deux parties d'au moins un composant électronique intégré.

4. Dispositif selon l'une quelconque des revendications précédentes, **caractérisé par le fait que** ladite plaque supérieure (6) présente au moins trois parties dont deux (49, 50) sont isolées électriquement et reliées électriquement à ladite bande de transmission (38).

5. Dispositif selon l'une quelconque des revendications précédentes, **caractérisé par le fait que** ladite plaque inférieure (60)
présentant au moins deux passages traversants (65, 66) au travers desquels s'étendent des moyens de connexion électrique (71, 72) de ladite bande de transmission (69) à des composants électroniques intégrés (67, 68), ces moyens de connexion électrique (71, 72) étant isolés électriquement de ladite cage (59).

6. Dispositif selon l'une quelconque des revendications précédentes, **caractérisé par le fait qu'**il est implanté dans un circuit intégré.

7. Dispositif selon l'une des revendications 1 à 6, **caractérisé par le fait qu'**il est implanté dans un endroit d'une plaquette de circuits intégrés formant une zone de découpe entre ces derniers.
